Europäisches Patentamt

European Patent Office

Office européen des brevets

(19)

(11) Publication number: **0 159 709**
**A2**

## (12) EUROPEAN PATENT APPLICATION

(21) Application number: **85104992.4**

(22) Date of filing: **24.04.85**

(51) Int. Cl.⁴: **H 03 M 1/38**

(30) Priority: **25.04.84 US 603574**

(43) Date of publication of application: **30.10.85**
**Bulletin 85/44**

(84) Designated Contracting States: **CH DE FR GB IT LI NL**

(71) Applicant: **VITAFIN N.V., Postbox 895 Rooi Catootje, Willemstad Curacao Netherlands Antilles (NL)**

(72) Inventor: **Mensink, Kornelis A., Cortenoeverseweg 76, NL-6971 JK Brummen (NL)**
Inventor: **Brouwer, Henk L., Vlierhof 9, NL-6951 MH Dieren (NL)**

(74) Representative: **Ebbinghaus, Dieter et al, v. FÜNER, EBBINGHAUS, FINCK Patentanwälte European Patent Attorneys Mariahilfplatz 2 & 3, D-8000 München 90 (DE)**

(54) Low power high speed analog to digital converter.

(57) Apparatus and method for converting an analog signal into a digital signal, utilizing three closely matched capacitors $C_1$, $C_2$, $C_3$) on a CMOS chip. A reference voltage is first sampled, divided and then compared with a sampled analog voltage, the comparison resulting in a first bit signal. If the bit signal is a 1, the divided signal is substracted from the sampled analog signal. After the initial sampling, the series of steps is carried n times to generate an n bit signal. The utilization of CMOS circuitry and just the three low capacitance capacitors, only two of which are charged during a conversion, results in extremely low power operation.

v. FÜNER  EBBINGHAUS  FINCK
VITAFIN N.V.

EPAB-32622.7

April 24, 1985

0159709

## LOW POWER HIGH SPEED ANALOG TO DIGITAL CONVERTER

### Field of the Invention

This invention relates to A/D converters and methods of analog to digital conversion and, more particularly, to fast low power A/D converters which are suitably fabricated on a chip and which utilize very low value capacitor elements.

### Background of the Invention

A/D converters, i.e., analog to digital converters, are very well known and have been used for decades in a wide variety of applications. There are several different types of basic design for A/D converters, some being better adapted for specific applications. A/D converters employing "resistor ladder" and "capacitor ladder" circuits are known in the art. However, each of these takes a substantial amount of power, which may or may not be acceptable depending upon the application. Also, particularly the capacitor ladder arrangement takes a substantial amount of space, which can be particularly disadvantageous in the design of a microelectronic chip. The prior art further includes CMOS A/D converters, which can be incorporated into a chip. Also, prior art A/D converters using subtraction as a technique of making the conversion are known, wherein the inputted analog signal is compared to a reference signal and then the reference signal is subtracted from it, following which the difference is multiplied by 10 and the comparison – subtraction routine is repeated, the series of steps being repeated n times to produce an n bit word. Reference is made to the following publications as exemplary of contemporary A/D

0159709

converter design:

Improvements in Monolithic Analogue to Digital Converter Design, Electronic Engineering, June 1980;

The Inside News on Data Converters, Electronics, July 17, 1980; and

Charge Balancing is Key to 10-Bit A-D Converter Chip, Electronics, October 6, 1981.

## Summary of the Invention

It is an object of this invention to provide an improved low power A/D converter which is advantageous for use in low power applications such as battery driven apparatus.

It is another object of this invention to provide a means and method of high speed low power analog to digital conversion.

It is another object of this invention to provide an improved low power A/D converter, and means of analog to digital conversion, the converter being simple and constructed of relatively few components.

It is a still further object of this invention to provide an improved low power A/D converter which can be efficiently and reliably fabricated on a chip, particularly a CMOS chip.

In view of the above objects, there is provided an A/D converter, a method of conversion from an analog to a digital electric signal, wherein a small number of low value capacitors are utilized for performing a series of steps comprising dividing a reference signal, comparing the divided signal and an analog-derived signal and generating a bit signal in response to the comparison, and then subtracting the divided reference signal value from the analog-derived value if the generated bit had a one value; and then repeating the series of steps n times to generate an n bit digital signal representative of the inputted analog signal. In the preferred embodiment, three capacitors are fabricated on a CMOS chip of matched identical capacitance value, the capacitors being switched in a predetermined logical sequence in accordance with the above described steps so as to achieve successive bit determinations.

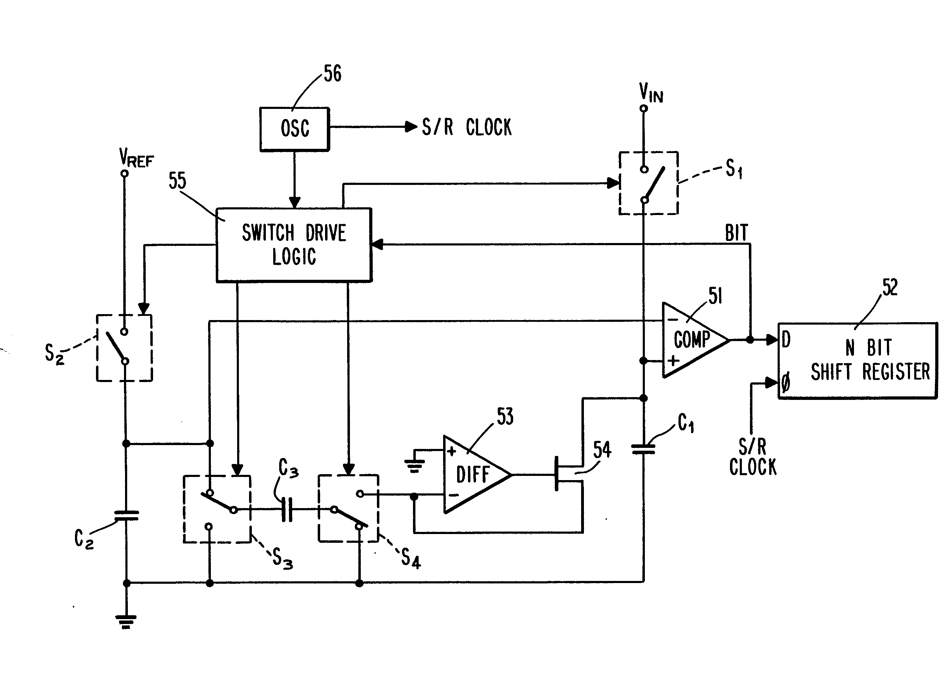

### Brief Description of the Drawing

The drawing is a circuit diagram of the preferred embodiment of the invention.

### Description of the Preferred Embodiment

Referring now to the drawing, there are two inputs illustrated, $V_{IN}$ which is the inputted analog signal to be converted, and $V_{REF}$, which is a reference voltage. The reference voltage is a well controlled and maintained voltage, and for the presently preferred embodiment on a CMOS chip is 1.26 volts. Four switches, namely $S_1$, $S_2$, $S_3$ and $S_4$ are utilized, it being understood that these switches are shown diagramatically and in practice are preferrably consituted by semi-conductor switches. As illustrated, each of the switches is shown in the off position. The switches are controlled by a switch drive logic circuit 55, which in turn receives an input from oscillator 56 Which provides basic timing signals. The sequence of controlling the four switches is discussed in greater detail hereinbelow. There are three capacitors illustrated, $C_1$, $C_2$ and $C_3$. These capacitors are preferrably very low value capacitors, suitably less than 50 pf, and in the preferred embodiment 20 pf each. As will become apparent, it is important that the capacitors be matched very closely, i.e. that they be of equal value. The remaining circuitry includes a difference amplifier 53 and transistor 54 illustrated connected between switch $S_4$ and capacitor $C_1$; a comparator 51 which receives an input at its + terminal from capacitor $C_1$ and an input at its - terminal from capacitor $C_2$; and an n bit shift register 52 which receives an input signal from the output of comparator 51 and a S/R clock signal inputted from oscillator 56 to its clock terminal.

In practice of the invention, the input voltage $V_{IN}$ is sampled by closing switch $S_1$. The input voltage is conventionally supplied from a time multiplexer or other source. The technique of sampling an analog signal is well known and understood in the art. As illustrated, when switch $S_1$ is closed, or on, $V_{IN}$ is placed directly across capacitor $C_1$, such that the circuit is initialized by loading the analog voltage which is to be converted across $C_1$. At the same time, a predetermined reference voltage $V_{REF}$ is sampled by $S_2$ and loaded onto capacitor $C_2$, i.e. capacitor $C_2$ charges to the value of $V_{REF}$. For carrying out this sampling step, switches $S_1$, $S_2$ and $S_3$ are on, and switch $S_4$ is in the off position.

The basic principle of operation is that the reference-derived voltage on capacitor $C_2$ is repeatedly divided by two and compared to the analog derived signal the divided signal being subtracted from the analog signal if the analog signal was larger. The successive divided voltages are equal to successive "1" values of the bits which represent the value of $V_{REF}$. For example, for a given $V_{REF}$, the first divided voltage equals $1/2 \ V_{REF}$, the next divided voltage equals 1/4, etc. until the nth divided voltage equals $1/2^n$ of $V_{REF}$. It is thus seen that the first divided value represents the most significant bit, and each successive divided value represents the next most significant bit. If eight such divisions are made, then conversion is made to provide an 8-bit output.

Continuing with the manner of operation, once the analog voltage has been sampled, the conversion loop is entered, under control of switch drive logic 55. Capacitor $C_2$ is placed in a loop with capacitor $C_3$, such that the voltage across capacitor $C_2$ is divided by 2. For this operation, all four switches are in the off position. Thus, the charge on $C_2$ discharges into $C_3$ until the two capacitors have equal voltage values, which means that the voltage value on each of $C_2$ and $C_3$ is 1/2 of that originally on $C_2$, assuming that the capacitance values are precisely equal. A comparison is then made in comparison circuit 51, of the divided voltage (across $C_2$ and/or $C_3$) and the voltage stored on capacitor $C_1$ (which initially was $V_{IN}$). If the voltage $V_{C1}$ across $C_1$ is greater than the voltage $V_{C3}$ across $C_3$, then the comparator produces a high output which is clocked into the shift register as a "one". This signal is also coupled into switch drive logic 55. If $V_{C1}$ is less than $V_{C3}$, then the comparator output is zero, and a zero value bit is entered into shift register 52.

Following the divide and comparison steps, the next step is conditional upon the value of the bit signal that has just been generated. If $V_{C1}$ was greater than $V_{C3}$, meaning that a "1" was generated then $V_{C3}$ is subtracted from $V_{C1}$. Switch drive logic circuit 55, under control of the bit received from comparator 51, sets switches $S_1$ and $S_2$ to the OFF condition, and $S_3$ and $S_4$ to the ON condition. In this state, with $C_3$ initially charged

V-125

such that $V_{C3}$ has some negative value, the output of difference amplifier 53 holds transistor 54 in an ON condition. Thus, $C_1$ and $C_3$ are effectively in series with each other, and the greater charge on $C_1$ discharges through $C_3$. This continues until voltage $C_3$ equals zero, which is the point at which the difference amplifier 53 ceases to provide a high output signal, and the point at which transistor 54 turns off. Note that one side of $C_3$ is held at ground through $S_3$, and the other side of $C_3$ is driven to zero by the action of the differential amplifier and the conducting transistor. The charge that discharges from $C_1$ is the same as that which passes through $C_3$ during the discharge state, and since the two capacitors are of equal value, the charge transfer must produce the same voltage difference across each capacitor, meaning that $C_1$ finishes the transition with a voltage which equals its starting voltage minus the precise voltage that had been across $C_3$. Thus a complete subtraction, $V_{C1} - V_{C3}$, is achieved.

If the comparison step resulted in a bit value of "zero", no subtraction is made, but $C_3$ is discharged to a value such that $V_{C3} = 0$, to initialize it for the next division step. Thus, following a bit equals zero result, switch drive logic 55 controls switches $S_1$, $S_2$ and $S_4$ to the OFF condition, and switch 3 to the ON condition, thereby simply shorting out $C_3$ and quickly discharging it.

After the steps that are outlined above have been completed, it is seen that the circuit is in condition to determine the next bit value, by simply repeating the process. For the division and comparison steps, all four switches are controlled to the OFF position; for the subtract step, switches $S_1$ and $S_2$ are

controlled to the OFF position and $S_3$ and $S_4$ to the ON position; and for the "no subtract" condition, switches $S_1$, $S_2$ and $S_4$ are controlled to the OFF position and switch $S_3$ to the ON position. By repeating the procedure an additional $n - 1$ times, such that a total of n comparisons are made, the initial analog signal $V_N$ is converted to an n bit digital signal, or word.

The conversion steps are summarized as follows:

START:

| 1. SAMPLE | $S_1$, $S_2$, $S_3$on; $S_4$off | go to 2 |
|-----------|--------------------------------|---------|

CONVERSION LOOP:

| 2. DIVIDE and COMPARE | $S_1$, $S_2$, $S_3$, $S_4$off | go to 3 if bit = 1; go to 4 if bit = 0 |
|-----------------------|-------------------------------|----------------------------------------|
| 3. SUBTRACT | $S_1$, $S_2$ off; $S_3$, $S_4$on | go to 2 and repeat loop |
| 4. NO SUBTRACT | $S_1$, $S_2$, $S_4$off; $S_3$on | go to 2 and repeat loop |

The loop of 2 and 3 or 4 is repeated n times for an n bit conversion.

Generalizing, it is to be seen that the invention is capable of providing an n bit output signal. However, it is to be understood that the accuracy of operation depends upon the number of bits into which the signal is divided. For example, for an 8-bit converter, the three capacitors must be matched to better than about 0.4%. Also, the bit total n determines the required value of the three capacitors relative to the parasitic capacitance. The parasitic capacitance that can be afforded to be added to each capacitor must be much less than $1/2^n$ times the capacitor, to achieve reliable operation.

The efficiency of the circuit and method of operation is derived from the fact that only three capacitors are used, and that for a given sampled analog signal only two of the capacitors are initially charged. The power utilized is essentially only that represented by the charge initially placed on capacitors $C_1$ and $C_2$. This assumes that the switching of the CMOS pairs, during the conversion step, contribute essentially no power drain. The efficiency of the operation is, of course, based upon very precise matching of the three capacitors. For present day techniques of fabricating CMOS chips, 20 pf capacitors can be obtained matched to about 0.1% accuracy. It is also necessary to fabricate the chip so that the parasitic capacitance is much smaller than the values of $C_1$, $C_2$ and $C_3$. It is to be understood that the capacitors may have to have a bias voltage maintained across them to keep them at an essentially constant value, i.e., to prevent them from acquiring capacitance values which are a function of the applied voltage. Further both the comparator and the difference amplifier must have low offset and fast response characteristics. In practice, A/D conversion using the apparatus and method of this invention may be performed in about 0.833 milliseconds. Using four clock cycles per bit, the conversion to an 8 bit digital word requires 32 clock cycles. The technology of generating clock signals and deriving timing signals to drive switches is well known in the art, and the precise design of switch drive logic 55 and oscillator 56 are a matter of design choice.

While the preferred embodiment has been described as being fabricated on a chip, and particularly a CMOS chip, it is to be understood that the apparatus and method may be practiced using other constructions. However, it is evident that the invention can provide an extremely low power high speed A/D converter, such as provides significant advantages over the existing art in areas such as implanted pacemakers and space applications where it is extremely important to conserve as much power as possible.

## Claims

1. Converter apparatus for converting an analog signal into a digital signal, said apparatus being fabricated on a CMOS chip and utilizing a plurality of capacitors $(C_1, C_2, C_3)$ and programmed switching circuitry $(55, S_1, S_2, S_3, S_4)$ for switching the charge held by said capacitors, characterized by the capacitance values of said capacitors $(C_1, C_2, C_3)$ being substantially matched.

2. The converter apparatus as described in claim 1, wherein said plurality of capacitors $(C_1, C_2, C_3)$ is limited to 3.

~~3. The converter apparatus as described in claim 2, wherein said capacitance value is no more than about 20 pico farads.~~

3 4. An analog to digital converter generating an n bit digital signal corresponding to an inputted analog signal, with microprocessor control of timed switching of controlled switching elements, characterized by

first storage means for storing an electrical signal, and first sampling means for sampling said analog signal and storing said sampled analog signal in said first storage means;

second storage means for storing an electrical signal and second sampling means for sampling a predetermined reference signal and storing said sampled reference signal in said second storage means;

divider means for dividing said signal stored in said second storage means, including third storage means for storing said divided electrical signal;

V-125

0159709

comparator means for comparing two different electrical signals and producing a bit signal representative of said comparison;

subtractor circuit means connected for controllably subtracting the signal stored in said third storage means from the signal stored in said first storage means, thereby producing a subtracted signal stored in said first storage means;

switch drive logic means for controllably switching said divider means in circuit relation with said second storage means so that the signal stored in said second storage means is divided by two and stored in said third storage means, switching said first storage means into connection with a first input of said comparator means and said second or third storage means into connection with a second input of said comparator means, so that said bit is produced as a result of said comparison, and switching said first and third storage means into circuit relation with said subtractor circuit so that the signal stored in said third storage means is subtracted from that stored in said first storage means.

4 5. The converter apparatus as described in claim 4, wherein said circuit for subtracting causes said third storage means to be discharged.

5 6. The converter apparatus as described in claim 4, wherein each of said three storage means is a capacitor, each of said capacitors being of substantially equal and matched capacitance value.

6. The converter apparatus as described in claim 4, wherein each of the recited elements is fabricated on a CMOS chip.

7. The converter apparatus of claim 6, characterized ~~and each of said storage means is a capacitor, said capacitors being~~ in that ~~of substantially matched capacitance value,~~ said capacitance value is ~~being~~ less than about 50 pico farads.

~~8. The converter apparatus as described in claim 4, where said capacitance value is about 20 pico farads.~~

8. The converter apparatus as described in claim 3, where said subtractor circuit comprises a difference circuit.

9. The apparatus as described in claim 3, comprising an n bit storage means for storing an n bit signal, having an input connected to receive the output of said comparator means, and timing means for controlling said controllable switching means to repeat said steps of dividing, comparing and conditionally subtracting, so as to generate a plural bit digital signal.

10. An analog to digital converter, integrated onto a CMOS chip, comprising:

a. first sampling means for sampling an analog voltage and first capacitor storage means for storing said sampled analog voltage;

b. second sampling means for sampling a reference voltage and second capacitor storage means for storing said sampled reference voltage;

c. capacitor divider means for carrying out the operation of dividing by two the voltage stored in said second capacitor storage means, and third capacitor storage means for storing said divided voltage;

d. comparison means for carrying out the operation of comparing said divided reference voltage with said stored sample voltage and producing a bit signal representative of said comparison;

e. subtractor means for carrying out the operation of substracting said divided voltage from said sampled analog voltage to obtain in said first storage means a substracted voltage signal when said bit signal has a one value; and

f. means for controlling said divider means, comparison means and subtractor means to repeat their respective operations until said sampled analog voltage has been transformed into an n bit digital signal.

12. In an analog to digital converter, the method of converting a sampled analog voltage to an n bit digital signal, characterized by:

dividing a reference voltage signal derived from a predetermined reference voltage by two to obtain a divided voltage, and comparing said divided voltage with a remaining sample voltage derived from said sampled analog voltage, and producing a binary bit output corresponding to said comparison;

substracting said divided voltage from said sample voltage when said binary bit has a one value; and

repeating the above steps n times to generate said n bit digital signal.

12

13. The method of converting a stored analog signal into an n bit digital signal, comprising

a first series of steps including dividing a reference signal by two and storing the divided reference signal, comparing the stored analog signal with said divided reference signal and generating and storing a bit signal representative of said comparison, said bit signal being a one when said stored analog signal is greater than said divided reference signal, conditionally substracting said divided reference signal from said analog signal when said bit signal is a 1 to obtain a subtracted analog signal;

a second series of steps including dividing by two the divided reference signal produced by the last dividing step and storing a new divided reference signal, comparing the subtracted analog signal with said new divided reference signal and generating a next bit signal representative of said comparison, and conditionally subtracting said new divided reference signal from said substracted analog signal when said next bit signal is a one to obtain a new substracted analog signal; and

carrying out the steps of said second series a total of n - 1 times, whereby each repeated series results in the generation of another bit signal so as to generate said n bit digital signal.

13

14. An analog to digital converter circuit, comprising:

a reference signal source for providing a predetermined voltage reference and an analog signal source for providing an analog input voltage;

three capacitors $C_1$, $C_2$ and $C_3$, said three capacitors being of substantially equal capacitance value;

a comparator circuit; a divide circuit including a difference amplifier;

switching circuit means for switchably interconnecting said three capacitors, said comparator circuit and said divide circuit; and

switch circuit control means for controlling said switching circuit means through a sequence of steps for generating an n bit digital signal representative of said analog signal.

15. The converter as described in claim 14, wherein said sequence of steps comprises a predetermined loop of steps, each said loop resulting in production of a bit, said loop of steps being controllably repeated n times to produce an n bit word.

16. The converter device as described in claim 14, comprising storage means for storing each of the produced bits.

17. The converter as described in claim 1, 7 or 13, wherein the capacitance value of each of said capacitors is no more than about 20 pico farads.

18. The converter as described in claim 16, wherein said capacitors are fabricated on a CMOS chip.

V-125

0159709

*18*
~~19~~. An n loop method of converting an analog signal into an n bit digital signal, utilizing a sample of said analog signal and a predetermined reference signal, wherein each loop is characterized by the steps of dividing a first signal derived from said reference signal by two to obtain a divided signal, comparing a second signal derived from said sampled analog signal with said divided signal and producing a bit signal having a value of 1 when said second signal is greater than said first signal and a value of 0 when said second signal is less than said first signal, and following the producing of a bit with a 1 value carrying out the step of substracting said divided signal from said second signal.

*19*
~~20~~. A method of converting an analog signal to a digital signal, characterized by a series of steps comprising dividing a second signal derived from a reference signal and comparing a first signal derived from said analog signal with said divided signal and generating a bit signal corresponding to said comparison, and subtracting said divided signal from said first signal when said bit signal has a one value, and carrying out said series of steps a total of n times for generating an n bit digital signal.